# EUROPEAN PATENT APPLICATION

(11) **EP 4 083 277 A1**
(43) Date of publication of application: **02.11.2022**
(21) Application number: 20907594.4
(22) Date of filing: 21.12.2020
(51) Int. Cl.: C30B 15/20

(54) **TEMPERATURE CONTROL SYSTEM AND METHOD FOR SEMICONDUCTOR SINGLE CRYSTAL GROWTH**

(30) Priority: 24.12.2019 CN 201911346042
(71) Applicant: Xuzhou Xinjing Semiconductor Technology Co., Ltd., Xuzhou, Jiangsu 221004 (CN)
(72) Inventor: HUANG, Mo, Xuzhou, Jiangsu 221004 (CN); LIU, Linyan, Xuzhou, Jiangsu 221004 (CN); GAO, Haitang, Xuzhou, Jiangsu 221004 (CN); LIU, Qi, Xuzhou, Jiangsu 221004 (CN); CHEN, Yi, Xuzhou, Jiangsu 221004 (CN); WANG, Shuangli, Xuzhou, Jiangsu 221004 (CN)
(74) Representative: Glawe, Delfs, Moll
(86) International application number: PCT/CN2020/137853
(87) International publication number: WO 2021/129546

(57) **Abstract**

A system and a method for controlling temperature of semiconductor single crystal growth. The system includes: an image collection apparatus , configured to capture an image of an edge line of a crystal rod that grows at a solid-liquid interface, so as to determine the width of the edge line at the interface; a heating apparatus, configured to heat a crucible; and a temperature control apparatus, configured to control the heating power of the heating apparatus, and the temperature control apparatus controls the heating power of the heating apparatus according to the width of the edge line. The system and the method for controlling temperature in the present disclosure can significantly reduce the defects of a growing semiconductor single crystal, and can help to reduce production costs, improve the production efficiency, etc.

## Description

### Technical Field

This disclosure relates to semiconductor single crystal growth technologies, and more particularly to a system and a method for controlling temperature of semiconductor single crystal growth.

### Background

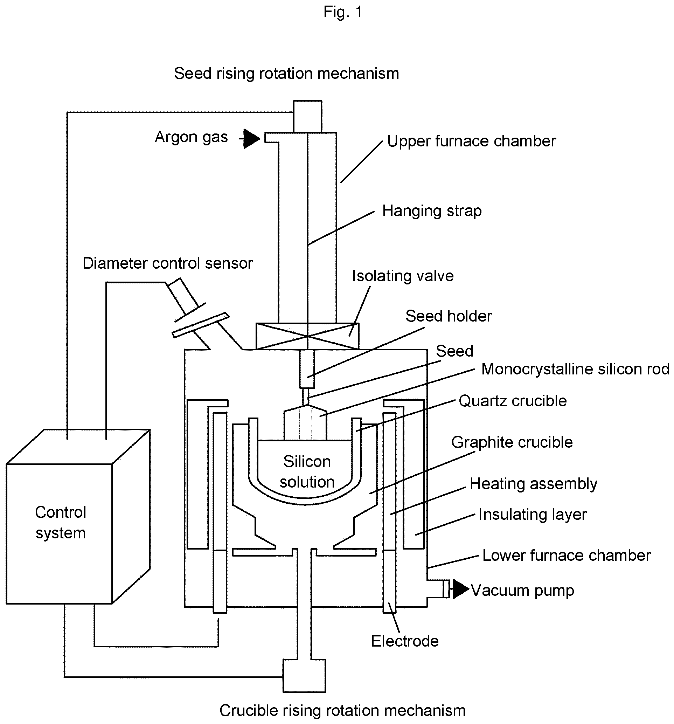

The Czochralski method is a main method for growing semiconductor single crystals. Fig. 1 is a schematic diagram of a typical Czochralski single crystal furnace that substantially includes a crucible, a heating assembly, a hanging strap, a viewing window, and a crystal solution. Taking a monocrystalline silicon as an example, a growth process of a monocrystalline silicon rod is as follows: in a Czochralski single crystal furnace shown in Fig. 1, a seed is first introduced into a crucible containing a silicon solution as a non-uniform crystal nuclei, then, a thermal field is controlled through the heating assembly, and the seed is rotated and slowly pulled upward by means of the hanging strap, so as to grow a semiconductor monocrystalline silicon rod having a crystallographic direction the same as the seed, and the crystallographic direction generally includes directions <100>, <110>, and <111>, and the control of the thermal field is very important for semiconductor single crystal growth.

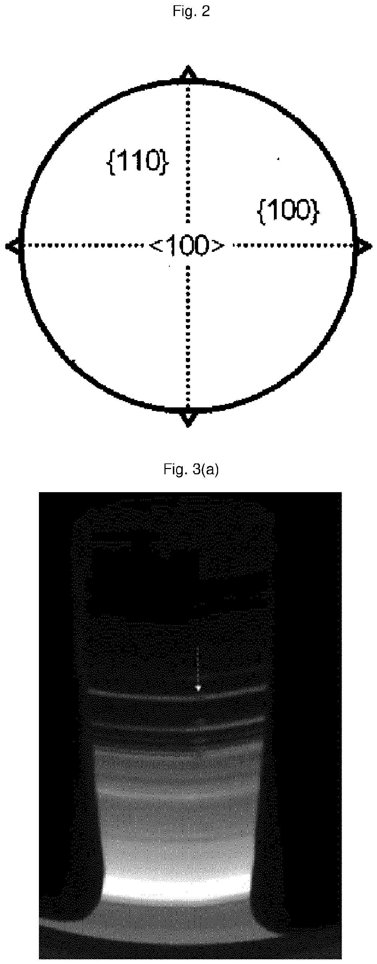

As semiconductor devices become smaller, the quality requirements for semiconductor wafers are also higher, especially requirements for surface defects, flatness and surface metal impurities of wafers are constantly increased. Therefore, it becomes more important to control the axial temperature gradient at the solid-liquid interface within a reasonable range, because it is closely related to the quality of the grown crystal rod. In recent years, it has been found that the axial temperature gradient at the solid-liquid interface is related to a width of an edge line of the growing crystal rod during semiconductor single crystal growth by the Czochralski method. As an example, Fig. 2 illustrates a sectional view of a crystal rod in a crystallographic direction <100>. In Fig. 2, four edge lines can be seen in a direction <110> of the crystal, and Stockmeier et al. gave a relationship [1] between the width of the edge line of the growing crystal rod in the crystallographic direction <100> and the axial temperature gradient at the solid-liquid interface. In addition, for an edge line of the crystal rod grown in other crystallographic directions, although the edge line of the growing crystal rod has different position and orientation, there is also a corresponding relationship between the width of the edge line and the axial temperature gradient at the solid-liquid interface. Nevertheless, so far, it still cannot accurately determine and effectively control the axial temperature gradient at the solid-liquid interface.

### Summary

In order to solve the above technical problems, the disclosure provides a system and a method for controlling temperature of semiconductor single crystal growth. To this end, the following technical solutions are used in the disclosure.

A system for controlling temperature of semiconductor single crystal growth includes: an image collection apparatus, configured to capture an image of an edge line of a crystal rod that grows at a solid-liquid interface, so as to determine a width of the edge line at the solid-liquid interface; a heating apparatus, configured to heat a crucible; and a temperature control apparatus, configured to control a heating power of the heating apparatus, and the temperature control apparatus controls the heating apparatus according to the width of the edge line.

A method for controlling temperature of semiconductor single crystal growth, including: an image of an edge line of a crystal rod that grows at a solid-liquid interface is captured by an image collection apparatus; and a width of the edge line is determined according to the captured image, and a crucible is heated according to the width of the edge line.

### Brief Description of the Drawings

Fig. 1 is a schematic diagram of a typical Czochralski single crystal furnace.
Fig. 2 illustrates a sectional view of a crystal rod in a crystallographic direction <100>.
Fig. 3(a) is a 2D image of a growing semiconductor single crystal, and Fig. 3(b) is a 2D image of a solid-liquid interface extracted from the image of Fig. 3(a).
Fig. 4 illustrates a schematic diagram of predicting a corresponding position and a width of an edge line by processing a 2D image of a solid-liquid interface according to an embodiment of the disclosure.
Fig. 5 illustrates a curve diagram of a relationship between a width of an edge line in a crystallographic direction <100> and an axial temperature gradient at an interface according to an embodiment of the disclosure.
Fig. 6 illustrates a schematic diagram of a heating apparatus for controlling an axial temperature gradient at a solid-liquid interface according to an embodiment of the disclosure.
Fig. 7 is a graphical representation of a stepwise heating power applied on a heater for a stepwise prior intermittent heating method according to an embodiment of the disclosure.

### Detailed Description of the Embodiments

Embodiments of the disclosure will be described in detail below with reference to the accompanying drawings, and the accompanying drawings and the embodiments herein are merely intended for illustration and not for limitation.

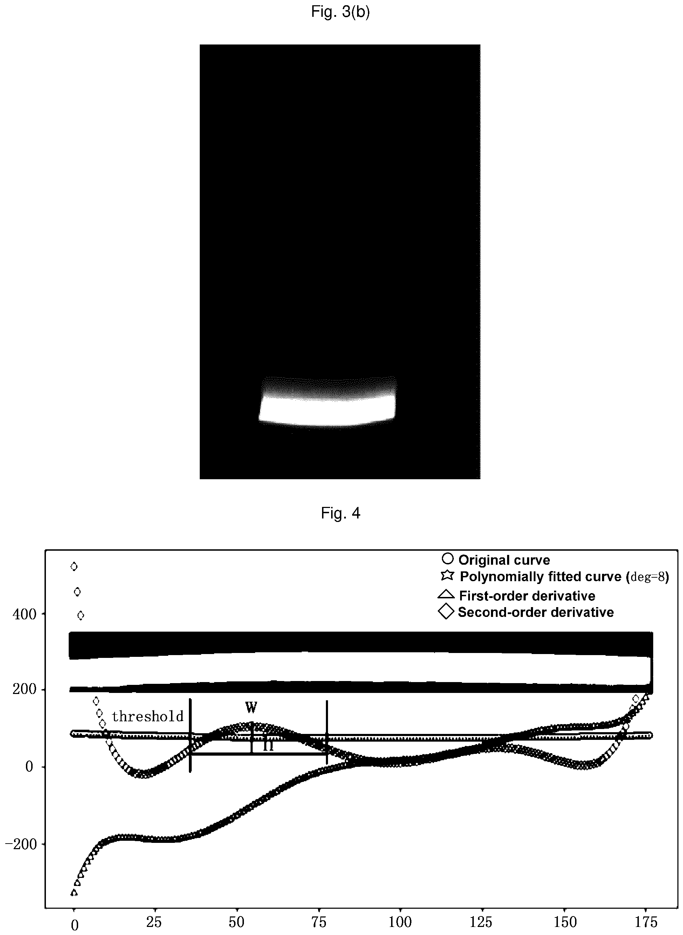

According to an embodiment of the disclosure, in order to determine a width of an edge line of a growing crystal, taking a picture of it is required first. Acquisition of an image of a camera can set to be triggered externally. In order to avoid excessive brightness or interference from an external light source, an IR bandpass filter can be installed outside a camera lens. Fig. 3(a) is a 2D image of a growing semiconductor single crystal captured by a camera. Preferably, the camera can be placed at a viewing window to take a picture of a growing crystal rod. In one embodiment, the camera can be a dual-line scan camera or any other high resolution camera. In another embodiment, in the case that a diameter of the growing crystal rod can be obtained, a single-line scan camera can be used, because the width of the edge line can be determined in conjunction with the diameter of the growing crystal rod and a real-time rotation speed of the crystal rod. As can be seen in Fig. 3(a), when a seed is continuously rotated and pulled up, a semiconductor crystal rod grows from a solution surface, where a position indicated by an arrow is a corresponding position of the edge line. Fig. 3(b) is a corresponding 2D image of a solid-liquid interface extracted from the image of Fig. 3(a). As shown in Fig. 3(b), a white part at the bottom is an image of the solid-liquid interface, which is roughly arc-shaped due to a shooting angle, and it can be seen that a curvature of the solid-liquid interface is different at the position of the edge line. In addition, the 2D image of the solid-liquid interface as shown in Fig. 3(b) can be further truncated to simplify processing and calculation, but it requires to contain at least the position of the edge line and its surrounding region.

After the 2D image of the solid-liquid interface is acquired, the image is processed by the following method so as to determine the position and the width of the edge line. Specifically, the operation of determining the position and the width of the edge line from the image includes steps of interface edge curve extraction, curvature calculation, and comparison between a curvature change and a threshold. Fig. 4 illustrates a schematic diagram of predicting the corresponding position and width of an edge line by processing a 2D image of a solid-liquid interface according to an embodiment of the disclosure. For ease of illustration, an upper part of Fig. 4 shows the 2D image of the solid-liquid interface as in Fig. 3(b). For the 2D image, various search methods can be used to find an interface edge curve, and the curvature can be calculated for the searched interface edge curve. As an example but not a limitation, as shown in Fig. 4, an original edge curve can be fitted by a polynomial and a curvature of an edge curve can be obtained by solving a first-order derivative of the fitted curve, herein because the polynomial fitting curve is well consistent with the original curve, they basically coincide as a single line in the graph. In addition, it can be seen from Fig. 4 that the curvature of the edge curve has a smaller value at a non-edge line position, and has a larger value at the corresponding position of the edge line, due to the larger curvature at the edge line. Next, determination of a curvature change is required, as shown in Fig. 4, a curvature change curve of the edge curve is obtained by performing second-order derivation on the edge curve. Then, a threshold line can be defined according to the curvature change of the edge curve, and a peak position of the curvature change curve and intersection positions of the curvature change curve and the threshold line can be determined, herein the peak position of the curvature change curve is the determined position of the edge line, and a distance between the two intersection positions of the curvature change curve and the threshold line is the determined width w of the edge line.

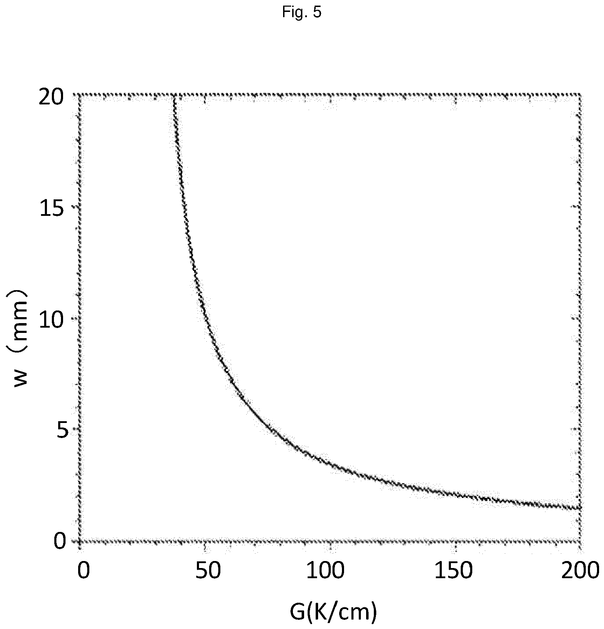

The width of the edge line is not constant. With the growth of the crystal rod, a heat radiation region is expanded, and the temperature gradient at the solid-liquid interface is higher, resulting in a smaller width of the edge line. Therefore, after the width of the edge line is determined according to the above, in order to keep the width of the edge line within a reasonable range, a theoretically established relationship needs to be used to control the axial temperature gradient at the solid-liquid interface according to a predetermined width of the edge line. As an example, Fig. 5 illustrates a curve diagram of a relationship between a width of an edge line in a crystallographic direction <100> and an axial temperature gradient at an interface. It can be seen from Fig. 5 that in order to maintain the width of the edge line within a range of 2mm-6mm relatively stable, the temperature gradient at the solid-liquid interface needs to be maintained at 60-90K/cm. The following describes an apparatus and a method for controlling temperature according to an embodiment of the disclosure.

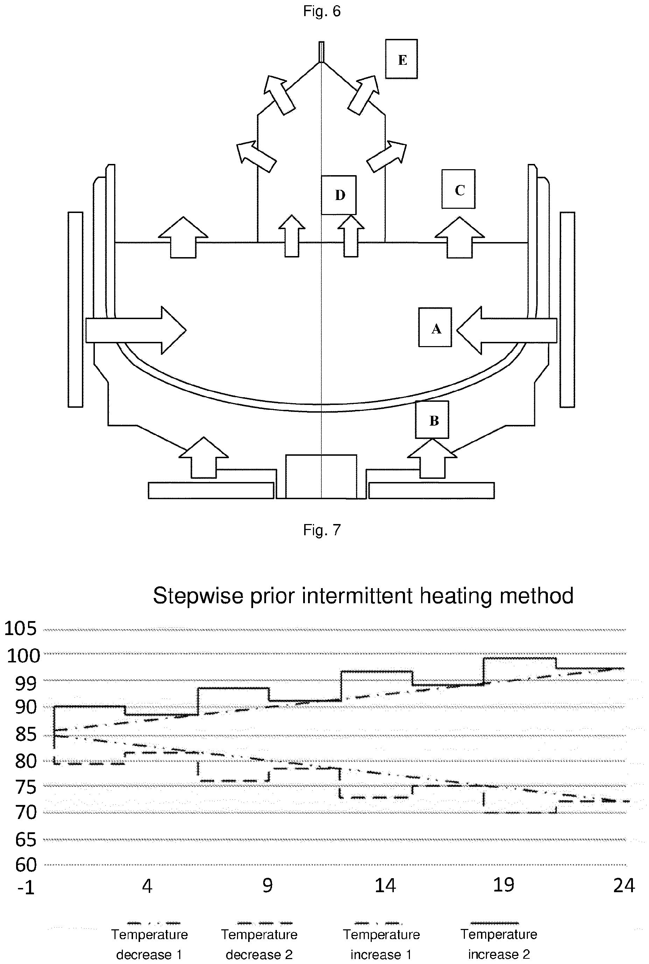

A conventional heating apparatus can include a main heater and a bottom heater, the main heater is placed on a side wall of a crucible to heat the crucible from the side wall and across the solid-liquid interface to prevent a liquid level from condensing. The conventional heating apparatus cannot achieve respective control on heating of the main heater and the bottom heater. The disclosure takes into account the fact that the main heater heats both sides of the interface at the same time by crossing the solid-liquid interface, causing a non-obvious change of the axial temperature gradient at the interface, while the bottom heater that is far away from the interface causes a more obvious change of the temperature gradient at the interface. Fig. 6 illustrates a schematic diagram of a heating apparatus for controlling a temperature gradient at a solid-liquid interface according to an embodiment of the disclosure. Herein, in order to effectively control the axial temperature gradient at the solid-liquid interface, the main heater and the bottom heater can be controlled separately according to needs. Preferably, heat is generated by resistive heating, is radiated to the crucible, and further conducted from the crucible to a melt so as to heat the melt. Because the bottom heater is far from the liquid level, its power can be higher, and preferably is 20% to 25% of a melt power. The main heater is closer to the liquid level, because too high or too low power has a great influence on the liquid level, a power of the main heater is controlled at 3% to 10%.

In Fig. 6, a heater at a side wall transfers heat in a direction of arrow A to heat the melt in a crucible from the side wall, and a heater at the bottom transfers heat in a direction of arrow B to heat melt in the crucible from the bottom. Then, a part of the heat is transferred to a melt surface through convection and diffusion of the melt, and is carried away by an argon gas on a surface (C), and a part of the heat is absorbed by phase transition of the solid-liquid interface and transferred to a crystal (D), and then radiated into an argon gas (E) from the surface of the crystal. The bottom heater is located on a melt side of the solid-liquid interface, so that the temperature gradient at the solid-liquid interface can be changed more efficiently. For example, when the width of the edge line becomes larger, it means that the axial temperature gradient at the solid-liquid interface becomes smaller. At this point, it is necessary to increase the power of a bottom heater and decrease the power of a side heater to lower a maximum temperature of the crucible in the melt and prolong a path of the buoyant vortex, thereby leading to an increase of the axial temperature gradient at the solid-liquid interface. Conversely, when the width of the edge line becomes smaller, it means that the axial temperature gradient at the solid-liquid interface is increased, that is, better heat dissipation is achieved. At this point, it is necessary to decrease the power of the bottom heater and increase the power of the side heater to raise the maximum temperature of the crucible wall in the melt and shorten the path of the buoyant vortex, thereby leading to a decrease of the axial temperature gradient at the solid-liquid interface.

In addition, since a conventional heater is usually applied with a constant variable power, which needs to take a long time to transfer heat to the solid-liquid interface. In order to increase a thermal equilibrium speed and avoid losing a single crystal structure, the disclosure uses a stepwise prior intermittent heating method to achieve thermal equilibrium more quickly, which is different from the conventional heating method. With the stepwise prior intermittent heating method, the heating power is gradually increased in an alternating manner of increase-decrease-increase according to an increase rate of the heating power, or is gradually decreased in an alternating manner of decrease-increase-decrease according to a decrease rate of the heating power.

The stepwise prior intermittent heating method according to the disclosure is specifically described below with reference to Fig. 7. Fig. 7 illustrates a stepwise increase and a stepwise decrease of the heating power when the stepwise prior intermittent heating method is applied. The following description is given by taking the stepwise decrease of temperature in Fig. 7 as an example. When the power of the heater is decreased from 84KW to 72KW, a power change rate and the number of steps is determined first. If the power changes too fast or too slow, the crystal growth can not be smooth; and the number of steps should also be selected reasonably. As an example, the power change rate is determined to be 1KW/MIN in Fig. 7, and the stepwise decrease of the heating power is divided into 24 steps, herein horizontal ordinates in Fig. 7 indicate the number of steps, and longitudinal ordinates indicate the heating power. Next, a power value of a 10^{th} step, for example, is estimated using a slope of the power change rate as a reference line, and this value is taken as a fixed value for a 1^{st} step to a 3rd step. Then, a value of a reference line at a 6^{th} step is determined as a fixed value for a 4^{th}step to the 6^{th} step. Then, by means of the reference line, a value of a 16^{th} step is estimated as a fixed value for the 6^{th}step to a 9^{th} step. Values of the subsequent steps are determined in a similar manner, so that the stepwise decrease of the heating power of a total of 24 steps is obtained. For the stepwise increase of the heating power, determining of the power value of each step is similar to that of the stepwise decrease, and thus will not be elaborated here.

In summary, in the disclosure, the axial temperature gradient at the solid-liquid interface is determined substantially by observing the width of the edge line of the growing semiconductor single crystal in real time, and then is controlled, so that the purpose of producing a defect-free semiconductor single crystal is achieved. The semiconductor single crystal produced by the system and method of the disclosure has no crystal defects, so that yield loss of a semiconductor chip factory due to the influence of crystal defects on a surface of a silicon wafer during a device manufacturing process is avoided. In addition, the system and method according to the disclosure can also improve production efficiency and reduce production cost.

The above-mentioned embodiments are merely preferred implementations of the disclosure, and are not intended to limit the technical solutions of the disclosure. All technical solutions that can be realized on the basis of the above-mentioned embodiments without creative work shall be deemed to fall within the scope of protection of the disclosure.
[1] L. Stockmeier, et al., J. Cryst. Growth, 515, 26(2019).

## Claims

1. A system for controlling temperature of semiconductor single crystal growth, comprising:
an image collection apparatus, configured to capture an image of an edge line of a crystal rod that grows at a solid-liquid interface, so as to determine a width of the edge line at the solid-liquid interface;
a heating apparatus, configured to heat a crucible; and
a temperature control apparatus, configured to control a heating power of the heating apparatus, wherein the temperature control apparatus controls the heating power of the heating apparatus according to the width of the edge line.

2. The system according to claim 1, wherein a growth direction of the crystal rod comprises a direction 100, a direction 110, or a direction 111.

3. The system according to claim 1, wherein the heating apparatus comprises a plurality of heaters respectively arranged at a side wall and a bottom of the crucible, wherein the heater at the side wall heats the crucible from the side wall, and the heater at the bottom heats the crucible from the bottom.

4. The system according to claim 3, wherein when the width of the edge line is less than a preset range, a heating power of the heater at the side wall is increased and a heating power of the heater at the bottom is decreased, so as to decrease an axial temperature gradient at the solid-liquid interface; and when the width of the edge line is greater than the preset range, the heating power of the heater at the side wall is decreased and the heating power of the heater at the bottom is increased, so as to increase the axial temperature gradient at the solid-liquid interface.

5. The system according to any one of claims 1 to 4, wherein the heating power of the heater is increased or decreased by a stepwise prior intermittent heating method.

6. The system according to claim 5, wherein with the stepwise prior intermittent heating method, the heating power is gradually increased in an alternating manner of increase-decrease-increase according to an increase rate of the heating power, or is gradually decreased in an alternating manner of decrease-increase-decrease according to a decrease rate of the heating power.

7. The system according to any one of claims 1 to 4, wherein the image collection apparatus is a dual-line scan camera or a single-line scan camera at a viewing window.

8. The system according to claim 1, wherein determining the width of the edge line from the image comprises steps of interface edge curve extraction, curvature calculation, and comparison between a curvature change and a threshold.

9. A method for controlling temperature of semiconductor single crystal growth, comprising:
capturing, by an image collection apparatus, an image of an edge line of a crystal rod that grows at a solid-liquid interface; and
determining a width of the edge line according to the captured image, wherein heating a crucible according to the width of the edge line.

10. The method according to claim 9, wherein when the width of the edge line is less than a preset range, a heating power at a side wall is increased and a heating power at a bottom is decreased, so as to decrease an axial temperature gradient at the solid-liquid interface; and when the width of the edge line is greater than the preset range, the heating power at the side wall is decreased and the heating power at the bottom is increased, so as to increase the axial temperature gradient at the solid-liquid interface.

11. The method according to claim 10, wherein the heating power is increased or decreased by a stepwise prior intermittent heating method.

12. The method according to claim 11, wherein with the stepwise prior intermittent heating method, the heating power is gradually increased in an alternating manner of increase-decrease-increase according to an increase rate of the heating power, or is gradually decreased in an alternating manner of decrease-increase-decrease according to a decrease rate of the heating power.

13. The method according to claim 9, wherein determining the width of the edge line from the image comprises interface edge curve extraction, curvature calculation, and comparison between a curvature change and a threshold.

14. The method according to claim 9, wherein a growth direction of the crystal rod comprises a direction 100, a direction 110, or a direction 111.
